# EUROPEAN PATENT APPLICATION

(11) **EP 4 847 923 A1**
(43) Date of publication of application: **02.12.2026**
(21) Application number: 26177438.4
(22) Date of filing: 08.05.2026
(51) Int. Cl.: G01R 19/00, G01R 15/14, H10W 72/00

(54) **IMPROVED POWER ELECTRONIC DEVICE WITH CURRENT SENSING**

(30) Priority: 27.05.2025 IT 202500012211
(71) Applicant: STMicroelectronics International N.V., 1228 Plan-les-Ouates, Geneva (CH)
(72) Inventor: PATTI, Davide Giuseppe, 20864 AGRATE BRIANZA (MB) (IT)
(74) Representative: Studio Torta S.p.A.

(57) **Abstract**

Electronic device including: a first and a second die (4,6), wherein a first and a second power electronic component (15,20) are formed, respectively; a first conductive clip (3;3'), which overlies the first and second dice (4,6) and electrically couples the first and second power electronic components (15,20); and a third die (8), which is arranged on the conductive clip (3;3'), and wherein a control circuit (30,32) is formed, which is electrically coupled to the first and second power electronic components (15,20) and controls the first and second power electronic components (15,20). The first conductive clip (3;3') forms a sensing resistor (103;303), which is electrically coupled to the first and second power electronic components (15,20). The control circuit (30,32) is electrically coupled to the sensing resistor (103;303) and is configured to sense a quantity indicative of a current that flows in the sensing resistor (103;303).

## Description

### Technical Field

The present invention relates to an improved power electronic device with current sensing.

### Background

As is known, electronic devices are available nowadays, which comprise, each, one or more semiconductive dice, which are arranged in a same package; at least one corresponding power electronic component, such as for example a corresponding power MOSFET transistor, is formed within each semiconductive die. Furthermore, the dice are electrically coupled in such a way that the respective electronic components form an electronic circuit. Electronic devices are also known whose electronic circuits are able to receive alternating electrical quantities, therefore they may be subject to polarity inversions; furthermore, it is known that electronic circuits may comprise circuits capable of sensing the intensity and/or direction of the current traversing them, for example in order to implement protection mechanisms. Typically, the current sensing occurs by using a so-called sensing resistor. Furthermore, typically each electronic device comprises a further die, wherein a control circuit is formed, which controls the power electronic components and is coupled to the sensing resistor.

That having been said, due to the number of dice and the circuit complexity, a need is felt to optimize the structure of such power electronic devices, for example to reduce, as much as possible, the size. It is therefore an aim of the present invention to meet at least in part this need.

### Summary

According to the present invention, a power electronic device is provided as defined in the appended claims.

### Brief Description of the Figures

For a better understanding of the present invention, preferred embodiments are presented, by way of non-limiting example, with reference to the attached drawings, wherein:
- Figure 1 schematically shows a cross-section of an electronic device;
- Figure 2 shows a circuit diagram of an electronic circuit implemented by the electronic device shown in Figure 1;
- Figure 3 schematically shows a perspective view with portions removed of the electronic device shown in Figure 1;
- Figures 4a-4d schematically show top views of portions of variants of the present electronic device;
- Figure 5 shows a portion of a circuit diagram relating to the electronic device shown in Figure 4d;
- Figure 6 schematically shows a cross-section of a portion of a variant of the present electronic device; and
- Figure 7 schematically shows a cross-section of a further variant of the present electronic device.

### Description of Embodiments

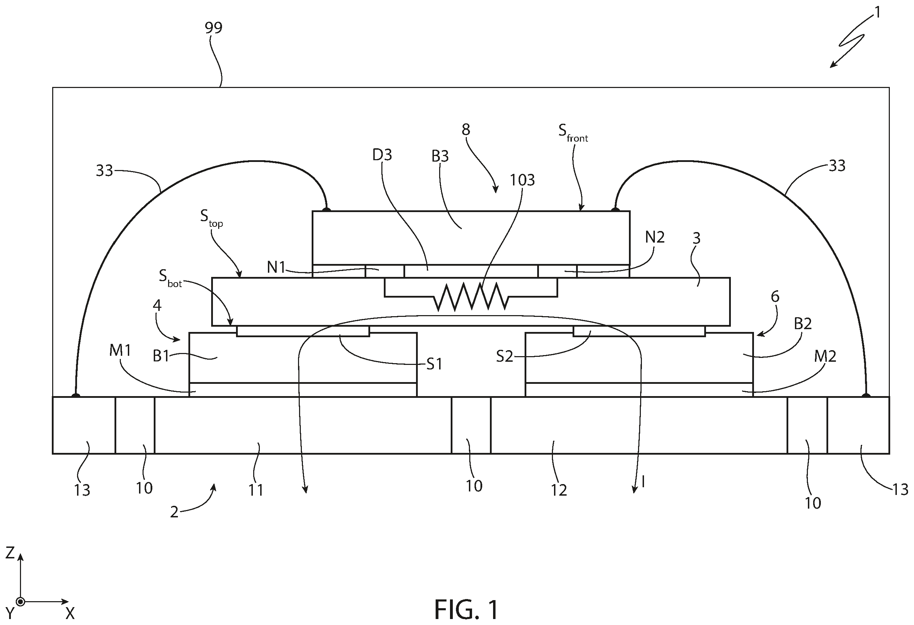

Figure 1 shows an electronic device 1, which comprises a support structure 2, a conductive clip 3 and a first, a second and a third die 4, 6, 8. Furthermore, Figure 1 shows an orthogonal reference system XYZ.

The support structure 2 comprises a dielectric structure 10, a first and a second internal pad 11, 12 and a plurality of peripheral pads 13 (two visible in Figure 1). The dielectric structure 10 has a planar shape and extends parallel to the XY plane. The first and second internal pads 11, 12 extend through an internal portion of the dielectric structure 10, have planar shapes and extend parallel to the XY plane; furthermore, the first and second internal pads 11, 12 are laterally offset parallel to the X-axis. The peripheral pads 13 extend so as to laterally surround the ensemble formed by the first and second internal pads 11, 12; furthermore, the peripheral pads 13 also extend through the dielectric structure 10 and, without any loss of generality, laterally face the side walls of the support structure 2, so as to be able to electrically couple with the outside world.

The first die 4 comprises: a respective lower metallization M1, which is soldered on the underlying first internal pad 11; a respective semiconductor body B1, which is formed for example by silicon or silicon carbide and overlies the lower metallization M1; and a respective source contact S1, which is formed by conductive material (for example, it is formed by one or more metal materials) and at least partially overlies the semiconductor body B1.

The second die 6 comprises: a respective lower metallization M2, which is soldered on the underlying second peripheral pad 12; a respective semiconductor body B2, which is formed for example by silicon or silicon carbide and overlies the lower metallization M2; and a respective source contact S2, which is formed by conductive material (for example, it is formed by one or more metal materials) and at least partially overlies the semiconductor body B2.

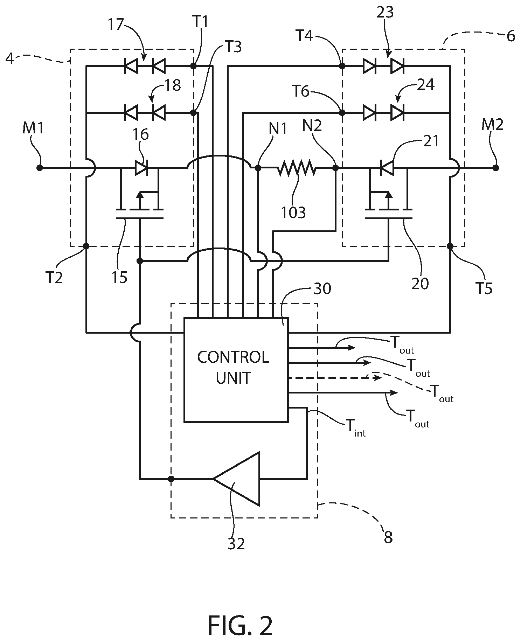

In greater detail, in the first die 4 there is formed, in a manner known per se, a first MOSFET transistor 15 (shown in Figure 2), which is for example an N-channel enhancement transistor. The lower metallization M1 and the source contact S1 form the drain terminal and the source terminal of the first MOSFET transistor 15, respectively. The first MOSFET transistor 15 also comprises a gate terminal, not shown in Figure 1, and a respective body diode 16, the anode and cathode of which are respectively connected to the drain terminal and the source terminal of the first MOSFET transistor 15. Without any loss of generality, in the first die 4 there are also formed a first and a second series circuit 17, 18, each of which is formed by a pair of respective series-connected diodes, the first series circuit 17 being connected between a first terminal T1 and a second terminal T2, so as to allow the current to flow in the direction of the second terminal T2, the second series circuit 18 being connected between a third terminal T3 and the second terminal T2, so as to allow the current to flow in the direction of the second terminal T2.

In the second die 6 there is formed, in a manner known per se, a second MOSFET transistor 20 (shown in Figure 2), which is for example an N-channel enhancement transistor; the lower metallization M2 and the source contact S2 form the drain terminal and the source terminal of the second MOSFET transistor 20, respectively. The second MOSFET transistor 20 also comprises a respective gate terminal, not shown in Figure 1, and a respective body diode 21, the anode and cathode of which are connected to the drain terminal and the source terminal of the second MOSFET transistor 20, respectively. Without any loss of generality, in the second die 6 there are also formed a third and a fourth series circuit 23, 24, each of which is formed by a pair of respective series-connected diodes, the third series circuit 23 being connected between a fourth terminal T4 and a fifth terminal T5, so as to allow the current to flow in the direction of the fifth terminal T5, the fourth series circuit 24 being connected between a sixth terminal T6 and the fifth terminal T5, so as to allow the current to flow in the direction of the fifth terminal T5.

Again with reference to Figure 1, the clip 3 is formed by metal material (for example, copper), has a planar shape and is delimited by a top surface Sₜₒₚ and a bottom surface S_{bot}, which are parallel to the XY plane. In particular, in this example, the clip 3 has the shape of a parallelepiped, therefore it is formed by a single monolithic region of metal material, i.e. it is formed by a single piece of metal material.

Furthermore, the bottom surface S_{bot} of the clip 3 is soldered to the source contacts S1, S2 of the first and second dice 4, 6, in such a way that the clip 3 extends above the first and second dice 4, 6, so as to form a conductive bridge between the source contacts S1, S2.

The third die 8 extends above the clip 3. In particular, the third die 8 comprises: a dielectric region D3, that overlies the clip 3; a respective semiconductor body B3, which is formed for example by silicon or silicon carbide and overlies the dielectric region D3; a first and a second contact N1, N2 of conductive material (for example, Tungsten, Titanium, aluminium alloys (AlCu)), which extend through the dielectric region D3, so as to face the underlying clip 3. In particular, the first and second contacts N1, N2 are soldered on the top surface Sₜₒₚ of the clip 3 and are arranged parallel to the X-axis, laterally spaced. The first and second contacts N1, N2 are therefore placed in electrical contact with corresponding portions of the clip 3.

In greater detail, as shown in Figure 2, a control circuit 30 and a drive circuit 32 are formed in the third die 8. The control circuit 30 has inputs that are respectively coupled to the first, second, third, fourth, fifth and sixth terminals T1, T2, T3, T4, T5 and T6. Furthermore, the control circuit 30 has a further pair of inputs, which are respectively coupled to the first and second contacts N1, N2; in particular, although not shown, the control circuit 30 may be electrically coupled to the first and second contacts N1, N2 by using corresponding through silicon vias, which are respectively aligned with the first and second contacts N1, N2, or by electrical connections of different type, each of which may comprise for example a respective wire bonding, in which case the first and second contacts N1, N2 may be laterally offset with respect to the semiconductor body B3, so as to allow such wire bondings to extend between the first and second contacts N1, N2 and the front surface (indicated by S_{front} in Figure 1, where any regions of the third die 8 arranged above the semiconductor body B3 are not shown) of the third die 8. In general, however, the way in which the control circuit 30 is electrically coupled to the first and second contacts N1, N2 is irrelevant to the purposes of the operation of the electronic device 1.

The control circuit 30 also comprises a plurality of output terminals, one of which, indicated by Tᵢₙₜ, is connected to the input of the drive circuit 32, while the other output terminals are generically indicated by Tₒᵤₜ. The output of the drive circuit 32 is connected to the gate terminals of the first and second MOSFET transistors 15, 20.

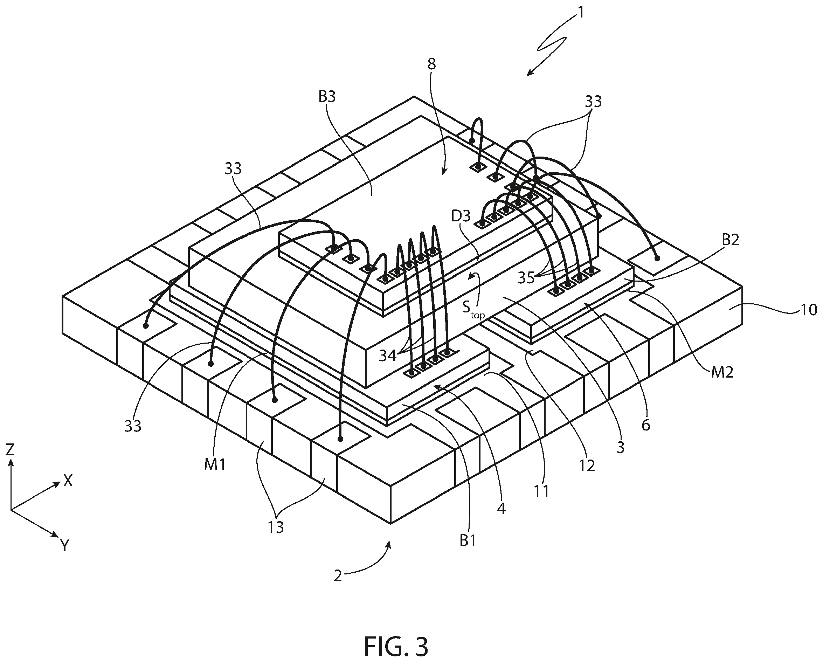

In greater detail, the output terminals Tₒᵤₜ of the control circuit 30 are connected to corresponding peripheral pads 13 by corresponding first wire bondings 33, shown by way of example in Figure 3. Furthermore, the first, second and third terminals T1, T2, T3 of the first die 4 are connected to the corresponding inputs of the control circuit 30 by respective second wire bondings 34, which extend between the first die 4 and the third die 8; the gate terminal of the first MOSFET transistor 15 is also connected to the output of the drive circuit 32 by a corresponding second wire bonding 34. The fourth, fifth and sixth terminals T4, T5, T6 of the second die 6 are connected to the corresponding inputs of the control circuit 30 by respective third wire bondings 35, which extend between the second die 6 and the third die 8; the gate terminal of the second MOSFET transistor 20 is also connected to the output of the drive circuit 32 by a corresponding third wire bonding 35.

The electronic device 1 also comprises a passivation region 99, which is formed for example by resin and overlies the support structure 2 so as to incorporate the first, second and third dice 4, 6, 8, the clip 3 and the first, second and third wire bondings 33, 34, 35. The passivation region 99 and the support structure 2 form the package of the electronic device 1.

The electrical resistances of the conductive paths that connect the first and second nodes N1, N2 to the source contact S1 and, respectively, to the source contact S2 are, as a first approximation, negligible with respect to the electrical resistance of the conductive path that connects the first and second nodes N1, N2 to each other.

In practice, from the electrical point of view, the first and second nodes N1, N2 are electrically coincident, as a first approximation, with the source terminal of the first MOSFET transistor 15 and, respectively, the source terminal of the second MOSFET transistor 20. The first and second MOSFET transistors 15, 20 are also electrically coupled in "back-to-back" mode.

Furthermore, the clip 3 forms a resistor 103 (symbolically shown in Figure 1), which is connected between the first and second nodes N1, N2 and functions as a current sensing resistor. In fact, since the first and second nodes N1, N2 are electrically coupled to the control circuit 30, the latter is coupled to the resistor 103 and is able to sense, for example, amplitude and direction of the voltage that drops on the resistor 103, such voltage being indicative of the intensity and direction of the current that flows through the resistor 103. The control circuit 30 therefore senses the intensity and direction of the current that flows through the resistor 103, which is indicative of the intensity and direction of the current that flows in at least one of the first and second MOSFET transistors 15, 20.

Furthermore, the control circuit 30 may implement a protection mechanism. For example, the control circuit 30 may sense whether the intensity of the current that traverses the resistor 103 exceeds a safety threshold and/or whether the direction of the current that traverses the resistor 103 is different from an expected direction, generating one or more output signals on corresponding output terminals Tₒᵤₜ. These output signals are therefore indicative of the current exceeding the safety threshold and/or of an error in the direction of the current and may be processed in a manner known per se by an external device (not shown), which is coupled to the corresponding peripheral pads 13. In this regard, and without any loss of generality, optionally the control circuit 30 may also determine, on the basis of electrical quantities relating to the first, second, third and fourth series circuits 17, 18, 23, 24, an estimate of the temperature and/or of a temperature range; in this case, the safety threshold and, more generally, the generation of the output signals may be a function of the temperature estimate and/or the temperature range.

Furthermore, the control circuit 30 generates a control signal on the output terminal Tᵢₙₜ, on the basis of which the drive circuit 32 controls the gate terminals of the first and second MOSFET transistors 15, 20, for example as a function of the specific application. Furthermore, the control signal may also be a function of the current sensed by the control circuit 30.

In particular, the drain terminals of the first and second MOSFET transistors 15, 20 coincide electrically with, respectively, the first and second internal pads 11, 12, which may be coupled to the outside world in a per se known manner. The first and second MOSFET transistors 15, 20 may therefore be controlled so that, for example, they are both turned on and are traversed by a same current I (shown qualitatively in Figure 1), which flows through the first and second MOSFET transistors 15, 20 with a vertical trend and traverses the clip 3 with an approximately horizontal trend, in one direction or the other; furthermore, the current I traverses the resistor 103 and has a direction and intensity that depend on the voltage present between the first and second internal pads 11, 12. The current I may be of the alternating type, therefore the electronic device 1 has a bidirectional conduction.

In practice, the clip 3 functions both as a support for the third die 8, and as an electrical connection between the first, second and third dice 4, 6, 8; furthermore, the clip 3 forms the resistor 103. In this manner, the bulk of the electronic device 1 may be contained. Furthermore, the value of the resistance of the resistor 103 may be set, for example on the basis of the geometric dimensions of the clip 3, the resistivity of the metal material that forms the clip 3 and the arrangement of the first and second contacts N1, N2. In this regard, in order to facilitate the sensing of the current that flows in the resistor 103 by the control circuit 30, the Applicant has observed how it is possible to impose that the resistance of the resistor 103 is comprised in the range [0.2-2] milliohm (mQ), boundaries included.

Variants of the electronic device 1 are also possible, in which the clip 3 differs from what has been previously described.

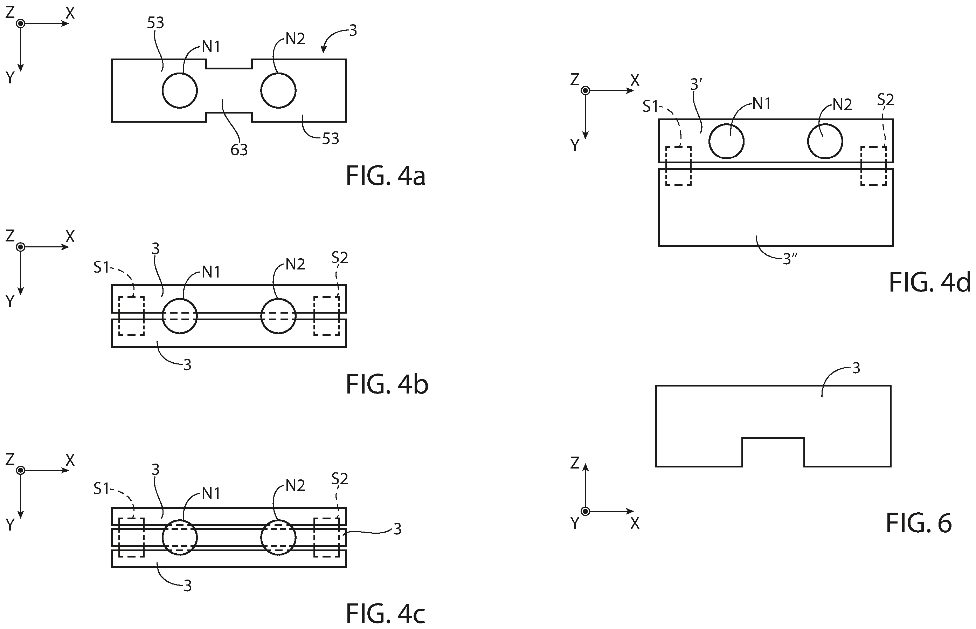

For example, as shown in Figure 4a, which shows only the clip 3 and the first and second contacts N1, N2, the clip 3 may still have a planar shape, parallel to the XY plane, and may have a shape such that, by sectioning the clip 3 parallel to the YZ plane, the width (measured parallel to the Y-axis) of the section varies as the coordinate along the X-axis of the section varies. In particular, in the example of Figure 4a, the clip 3 comprises two equal and symmetrical enlarged end portions 53 and an intermediate portion 63, which connects the enlarged end portions 53 and has a width smaller than the width of the latter. The first and second contacts N1, N2 each contact a corresponding enlarged end portion 53.

Again with reference to Figure 4a, it shows as an example how the first and second contacts N1, N2 may have an approximately circular shape in top view. In general, however, the first and second contacts N1, N2 may have any shape, regardless of the shape of the clip 3. Figure 4a also shows that the first and second contacts N1, N2 may have a maximum width smaller than the maximum width of the clip 3.

In practice, the shape of the clip 3 shown in Figure 4a allows to control more precisely the value of the resistor 103, as well as improve the mechanical coupling between the clip 3 and the resin that forms the passivation region 99. To this end, variants (not shown) are also possible, in which the clip 3 is holed.

Figure 4b instead shows a variant in which a pair of clips 3 is present; in particular, in addition to the pair of clips 3 and the first and second contacts N1, N2, Figure 4b shows only the source contacts S1, S2 (not shown in Figure 4a).

In detail, the clips 3 have the shape of elongated parallelepipeds parallel to the X-axis and are offset along the Y-axis, so as to be arranged side by side and coplanar to each other; although not shown, the third die 8 overlies both clips 3. Without any loss of generality, the two clips 3 may be equal to each other. Furthermore, both the first and second contacts N1, N2 contact both clips 3. In addition, each clip 3 has ends that are respectively coupled to the underlying source contacts S1, S2, by soldering.

As shown in Figure 4c, the number of clips 3 may also be greater than two; in particular, in the example shown in Figure 4c three clips 3 are present arranged side by side and coplanar, overlaid by the third die 8 (not shown). Both the first and second contacts N1, N2 contact all three clips 3. Furthermore, each clip 3 has ends that are respectively coupled to the underlying source contacts S1, S2, by soldering. As the number of clips increases, the precision with which it is possible to impose the resistance value of the resistor 103 increases and the parasitic inductance is reduced.

Figure 4d instead shows a variant in which a first clip 3' and a second clip 3" are present, which are arranged side by side and coplanar to each other and have the shape of parallelepipeds elongated along the X-axis and offset along the Y-axis, the width along the Y-axis of the first clip 3' being smaller than the width of the second clip 3"; the first clip 3' therefore has a resistivity per length unit (along the X-axis) greater than the corresponding resistivity of the second clip 3". The first and second contacts N1, N2 contact the underlying first clip 3', but do not contact the second clip 3". Furthermore, both the first and second clips 3', 3" have ends that are respectively coupled to the underlying source contacts S1, S2, by soldering.

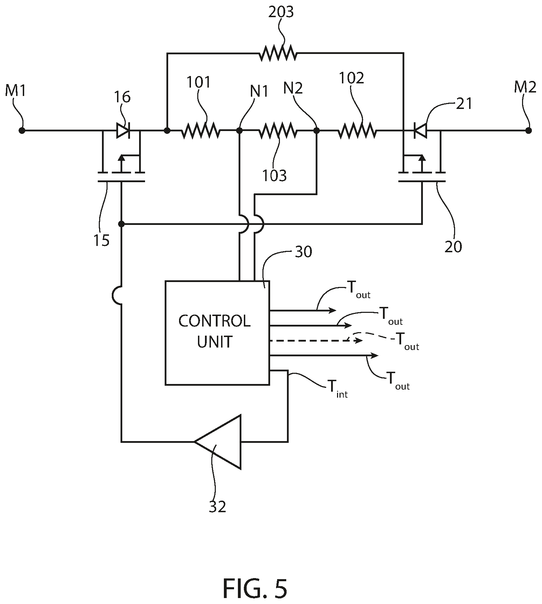

In practice, the resistor 103 is formed only by the first clip 3'. Furthermore, from the circuit point of view, an additional resistor 203 is present, as shown in Figure 5. In particular, the additional resistor 203 is formed by the second clip 3" and has a resistance value lower than the resistance value of the resistor 103 and is connected between the source terminals of the first and second MOSFET transistors 15, 20. Furthermore, in this embodiment, the resistance between the source terminals of the first and second MOSFET transistors 15, 20 and the first and second contacts N1, N2 is not negligible. For this reason, between the source terminal of the first MOSFET transistor 15 and the first contact N1 a first coupling resistor 101 is present; similarly, between the source terminal of the second MOSFET transistor 20 and the second contact N2 a second coupling resistor 102 is present. The control circuit 30 is still electrically connected to the first and second contacts N1, N2.

The variant shown in Figure 4d allows to sense even extremely low currents (for example, equal to 0.1A), thanks to the relatively high resistance value of the resistor 103 (for example, comprised between 10mΩ and 100mQ), which is therefore subject to a voltage drop sensable by the control circuit 30; the additional resistor 203 (for example, with a resistance about one hundred times lower than the resistance of the resistor 103) still allows to obtain a low power dissipation.

Variants are also possible that are respectively equal to the variants previously described, but in which, in the XZ plane, the clip(s) has/have a different section with respect to what has been described. For example, as shown in Figure 6, which refers for example to the case in which only one clip 3 is present having a rectangular shape in the top view, the clip 3 has a section with a bridge profile in a plane parallel to the XZ plane. In this case, the bases of the bridge are soldered to the source contacts S1, S2, with resulting mechanical advantages, since the bridge structure allows to better withstand the thermomechanical stresses caused by the different coefficients of thermal expansion of the clip 3 and of the first and second dice 4, 6.

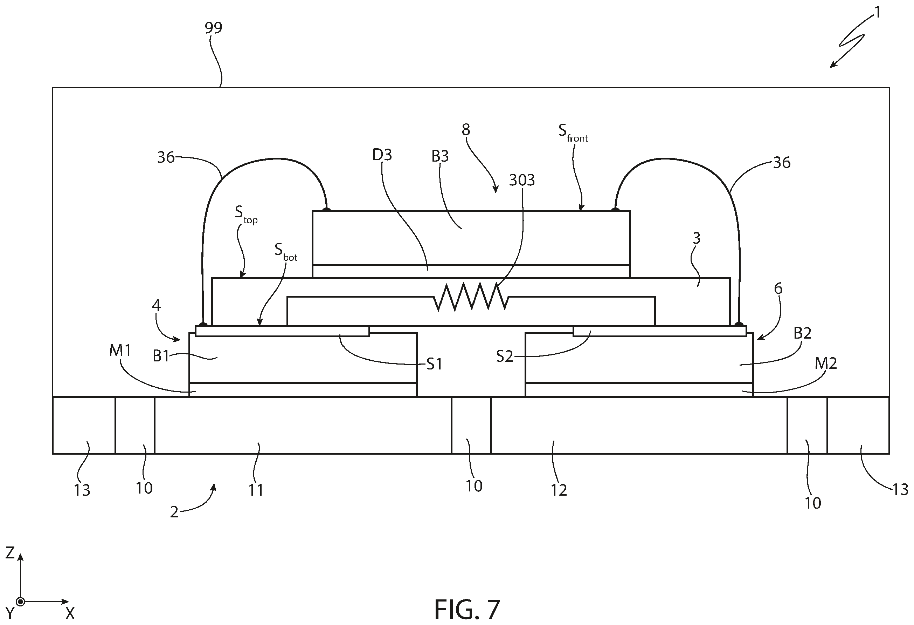

Figure 7 instead shows a further embodiment, that is now described limitedly to the differences with respect to what has been shown in Figures 1-3. For reasons of clarity, the wire bondings 33 are not shown in Figure 7.

In detail, the first and second contacts N1, N2 are absent. Furthermore, the source contacts S1, S2 protrude laterally with respect to the clip 3, in such a way that each of the source contact S1 and the source contact S2 includes a respective exposed portion.

The electronic device 1 also comprises a pair of wire bondings 36, each of which extends between the front surface S_{front} of the third die 8 and the exposed portion of a corresponding source contact S1, S2. The wire bondings 36 are coupled to the control circuit 30 and electrically connect the control circuit 30 to the source contacts S1, S2. In this manner, the resistor (here indicated by 303) is formed by the portion of the clip 3 that extends between the source contacts S1, S2. The resistor 303 is therefore electrically interposed between the source contacts S1, S2.

In practice, the circuit diagram remains the same as shown in Figure 2, however the embodiment shown in Figure 7 allows to control more precisely the resistance value of the resistor 303, that no longer depends on the arrangement of the first and second contacts N1, N2.

Even in the case of the embodiment shown in Figure 7, variants are possible in which the clip (or clips) is of the same type described with reference to any of Figures 4a-4c or 6.

The advantages that the present electronic device allows to obtain are clear from the preceding description.

In particular, the structure of the electronic device 1 is simplified, since the sensing resistance is formed by the same element that serves to support the third die 8, without the need to adopt, in addition to a support structure for the third die 8, a resistor specifically dedicated to the function of current sensing, the arrangement and electrical coupling of this resistor with respect to the first, second and third dice inevitably leading to an increase in complexity.

Finally, it is clear that modifications and variations may be made to what has been described and illustrated herein without thereby departing from the scope of the present invention, as defined in the attached claims.

For example, in lieu of the previously mentioned solderings, conductive bondings may be adopted. Therefore, the clip 3 may be for example mechanically and electrically coupled to the first and second dice 4, 6 by conductive bonding to the source contacts S1, S2, instead of by soldering. Similarly, the first and second contacts N1, N2 may also be mechanically and electrically coupled to the clip 3 by conductive bonding, instead of by soldering.

As previously mentioned, all the previously mentioned clips may be formed, each, from a corresponding single piece of conductive material.

The first, second, third and fourth series circuits 17, 18, 23, 24 may be omitted. Furthermore, components that are additional with respect to what has been described may be formed in the first and second dice 4,6.

The first and second transistors may be different with respect to what has been described; for example, the first and second transistors may be of the IGBT type. Furthermore, both the first and second MOSFET transistors 15, 20 may be replaced by a corresponding voltage-controlled, vertically conducting field-effect electronic component.

Furthermore, each of the first, second and third die 4, 6, 8 may comprise further regions with respect to what has been shown, such as for example front passivation regions or contact conductive regions.

## Claims

1. An electronic device comprising:
- a first and a second die (4,6), wherein a first and a second power electronic component (15,20) are formed, respectively;
- a first conductive clip (3;3'), which overlies the first and second dice (4,6) and electrically couples the first and second power electronic components (15,20); and
- a third die (8), which is arranged on the conductive clip (3;3'), and wherein a control circuit (30,32) is formed, which is electrically coupled to the first and second power electronic components (15,20) and is configured to control the first and second power electronic components (15,20);
and wherein the first conductive clip (3;3') forms a sensing resistor (103;303), which is electrically coupled to the first and second power electronic components (15,20); and wherein the control circuit (30,32) is electrically coupled to the sensing resistor (103;303) and is configured to sense a quantity indicative of a current that flows in the sensing resistor (103;303).

2. The electronic device according to claim 1, wherein the sensing resistor (103;303) has a resistance comprised in the range [0.2-2] mΩ.

3. The electronic device according to claim 1 or 2, wherein the first and second power electronic components (15,20) each comprise a respective conduction terminal; and wherein the first and second dice (4,6) each comprise a respective contact region (S1,S2), which forms the conduction terminal of the corresponding power electronic component (15,20); and wherein the first conductive clip (3;3') is mechanically and electrically coupled to the contact regions (S1,S2) of the first and second dice (4,6).

4. The electronic device according to claim 3, further comprising at least one second conductive clip (3;3"), which is arranged alongside the first conductive clip (3;3') and is mechanically and electrically coupled to the contact regions (S1,S2) of the first and second dice (4,6), said sensing resistor (103;303) also being formed by said second conductive clip (3;3").

5. The electronic device according to claim 3, further comprising a second conductive clip (3"), which is arranged alongside the first conductive clip (3') and is mechanically and electrically coupled to the contact regions (S1,S2) of the first and second dice (4,6); and wherein the first and second conductive clips (3',3") are elongated along a first direction (X), the first conductive clip (3') having a width smaller than the width of the second conductive clip (3") along a second direction (Y) transversal to the first direction (X); and wherein the second conductive clip (3") forms an additional resistor (203) different from said sensing resistor (103).

6. The electronic device according to any of the preceding claims, wherein the third die (8) comprises a first and a second contact (N1,N2), which are laterally offset and are placed in electrical contact with the first conductive clip (3;3'), the control circuit (30,32) being electrically coupled to the first and second contacts (N1,N2), the sensing resistor (103) being electrically interposed between the first and second contacts (N1,N2).

7. The electronic device according to any of the claims 1 to 4, wherein the control circuit (30,32) is electrically coupled to the contact regions (S1,S2) of the first and second dice (4,6); and wherein the sensing resistor (303) is electrically interposed between the contact regions (S1,S2) of the first and second dice (4,6).

8. The electronic device according to any of the preceding claims, wherein the first and second power electronic components (15,20) are voltage-controlled, vertically conducting field-effect electronic components.

9. The electronic device according to claim 8, wherein the first and second power electronic components (15,20) are MOSFET or IGBT transistors.

10. The electronic device according to any of the preceding claims, further comprising a support structure (2) that comprises a first and a second conductive pad (11, 12); and wherein the first and second dice (4,6) comprise a first and a second lower metallization (M1,M2), respectively, which are mechanically and electrically coupled, respectively, to the first and second conductive pads (11, 12).
